# EUROPEAN PATENT APPLICATION

(11) **EP 4 572 131 A1**
(43) Date of publication of application: **18.06.2025**
(21) Application number: 24220042.6
(22) Date of filing: 16.12.2024
(51) Int. Cl.: H02P 29/024

(54) **MOTOR FAULT DETECTION AND REMAINING USEFUL LIFE PREDICTION**

(30) Priority: 15.12.2023 IN 202311085675
(71) Applicant: Eaton Intelligent Power Limited, Dublin D04 Y0C2 (IE)
(72) Inventor: Baronijan, Armen, Dublin 4, D04 Y0C2 (IE); Laskovy, Andrew Michael, Dublin 4, D04 Y0C2 (IE); Somayajula, Deepak Balaji, Dublin 4, D04 Y0C2 (IE); Vaghasiya, Kamal Madhubhai, Dublin 4, D04 Y0C2 (IE); Das, Asish, Dublin 4, D04 Y0C2 (IE); Sreenilayam Raveendran, Ranjith Kumar, Dublin 4, D04 Y0C2 (IE); Singh, Gurmeet, Dublin 4, D04 Y0C2 (IE)
(74) Representative: Schwan Schorer & Partner mbB

(57) **Abstract**

Disclosed are systems and methods for detecting motor faults and predicting remaining useful life of the motor. The disclosed systems may receive sensor data that is provided to a model. The model is trained by utilizing sensor data for motor operation. The model utilizes the sensor data to output a health index of the motor. The health index is then utilized to predict a remaining useful life of the motor. This prediction can be automatically relayed to an operator, system, or other user for further action.

## Description

### CROSS-REFERENCE TO RELATED APPLICATION

This application claims the benefit of India Provisional Patent Application No. 202311085675, filed December 15, 2023, which is incorporated by reference herein in its entirety.

### BACKGROUND

Motors, such as those used to drive pumps in various services, often experience failures related to several types of stator faults. Motor failure causes equipment downtime and subsequent reactive scheduling of maintenance. A system for detecting motor faults and predicting remaining useful life of the motor may be desired. Additionally, a fault may be accompanied by the presence of a detected feature. However, in some instances, for example where a motor is operating at a relatively high speed or torque, the feature may be detected even when the motor is still healthy. A system that can determine a current health of the motor even in such situations may be desired.

### SUMMARY

In general, the subject matter of this disclosure relates to methods and systems for detecting motor fault detection and predicting remaining useful life of the motor. The disclosed systems may receive sensor data that is provided to a model. The model is trained by utilizing current, speed, and/or range of load data for healthy motor operation. The model utilizes the sensor data to output a health index of the motor. The health index is then utilized to predict a future time at which the motor will be "unhealthy" (for example, may experience a fault, failure, degraded state, or other negative event). This prediction can be relayed to an operator or other user (for example, an aircraft pilot or maintenance scheduler) for further action.

This summary is provided to introduce a selection of concepts in a simplified form that are further described below in the Detailed Description. This summary is not intended to identify key features or essential features of the claimed subject matter, nor is it intended to be used to limit the scope of the claimed subject matter.

### BRIEF DESCRIPTION OF THE DRAWINGS

Non-limiting and non-exhaustive examples are described with reference to the following Figures.
FIG. 1 illustrates an example system for performing fault detection and remaining useful life prediction, according to an example.
FIG. 2 illustrates an example architecture for performing fault detection and remaining useful life prediction, within the example system of FIG. 1.
FIG. 3 illustrates an example flowchart for a diagnostic application of the architecture of FIG. 2.
FIG. 4 illustrates an example architecture for a prognostic application of the architecture of FIG. 2.
FIG. 5A illustrates an example health indicator trend over time for an interturn (IT) fault.
FIG. 5B illustrates an example health indicator trend over time for a winding short circuit (WSC) fault.
FIG. 5C illustrates an example health indicator trend over time for both an interturn (IT) fault and a winding short circuit (WSC) fault.
FIG. 6 illustrates an example plot of predicted remaining useful life of a motor compared to actual remaining useful life data.
FIG. 7A illustrates an example method for training a fault detection and remaining useful life prediction model, according to an example.
FIG. 7B illustrates an example method for performing fault detection and remaining useful life prediction, according to an example.
FIG. 8 illustrates an example block diagram of a computing system.

### DETAILED DESCRIPTION

In the following detailed description, references are made to the accompanying drawings that form a part hereof, and in which are shown by way of illustrations specific embodiments or examples. These aspects may be combined, other aspects may be utilized, and structural changes may be made without departing from the present disclosure. Examples may be practiced as methods, systems, or devices. Accordingly, examples may take the form of a hardware implementation, an entirely software implementation, or an implementation combining software and hardware aspects. The following detailed description is therefore not to be taken in a limiting sense, and the scope of the present disclosure is defined by the appended claims and their equivalents.

Motors often experience failures related to several types of stator faults. Motor failure causes equipment downtime and subsequent reactive scheduling of maintenance. In some examples, where the motor is installed in a system that is critical and/or where maintenance is difficult to schedule or perform, an unexpected or unpredicted failure can be especially detrimental to the overall process (for example, a motor that is driving a fuel pump in an aerospace environment, such as onboard an airplane or jet). A fault may be accompanied by the presence of a detected feature. However, in some instances, for example where a motor is operating at a relatively high speed or torque, the feature may be detected even when the motor is still healthy; this makes detection and prediction of motor faults over the life of the motor difficult.

The disclosed systems may receive sensor data that is provided to a model. The model is trained by utilizing current, speed, and/or range of load data for healthy motor operation. At a diagnostic application, a model/algorithm determines, based on the sensor data, a health index of the motor. This may include determining whether there is a fault, and may include determining a type of the fault. A filtering algorithm is then applied to the health index at a prognostic application to predict a future time at which the motor will be "unhealthy" (for example, may experience a fault, failure, degraded state, or other negative event). This prediction can be relayed to an operator or other user for further action. For example, if the motor is present on an aircraft, when a fault is predicted, a notification (such as an icon appearing or an indicator light illuminating) may be presented to a pilot in the cockpit of the aircraft. In an example, a notification may be presented to a user (such as a maintenance scheduler user) on a user interface of a device. The user may schedule the motor for preventative maintenance at a time appropriate to minimize downtime of the aircraft and to replace or fix the motor before it ceases to function. In some examples, a motor may be one of several motors. If one motor is predicted to need maintenance, a user may schedule for multiple (or all) motors of the network of motors to be replaced at the same time, to minimize downtime and prevent further faults and future maintenance on other motors.

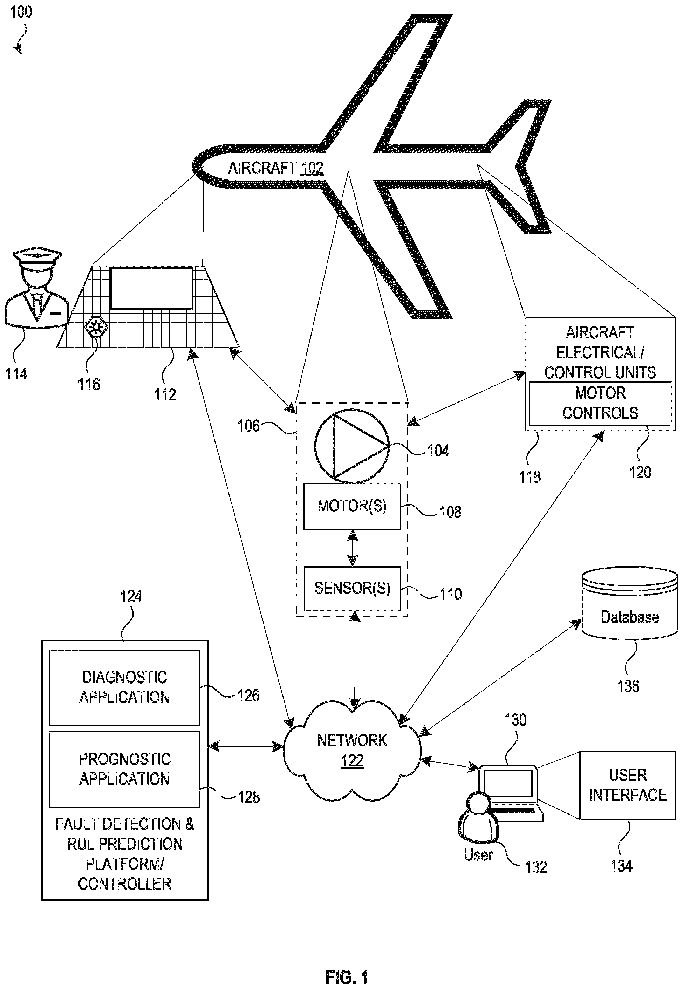

These and other examples will be explained in more detail below with respect to FIG. 1 through FIG. 8.

FIG. 1 illustrates an example system 100 for performing fault detection and remaining useful life prediction. In some examples, the devices, applications, and systems of system 100 are configured to send and receive data (for example, to communicate) via network 122. In some examples, as described herein, network 122 may include a computer network, an enterprise intranet, the Internet, a LAN, a Wide Area Network (WAN), wireless transmission mediums, wired transmission mediums, other networks, and combinations thereof. Although network 122 is shown as a single network in FIG. 1, this is shown as an example and the various communications described herein may occur over the same network or a number of different networks.

A process or entity, such as aircraft 102, may include at least one motor 108. In some examples, motor 108 is coupled to a pump 104 to drive the pump 104. In some examples, aircraft 102 may include a plurality of (for example, a network of) pumps 104 and associated drive motors 108. In some examples, the pump 104 is a fuel pump. In some examples, the motor 108 is an electric motor (for example, a radial flux motor, axial flux motor, linear motor, or other appropriate type). In some examples, motor 108 may be subject to one or more types of faults related to the motor winding. For example, motor 108 may experience one or more of: an interturn fault ("IT fault," where two turns of the same coil are shorted); phase-to-phase fault ("PP fault," winding-to-winding fault, where leakage current flows from one phase winding to another phase winding, for example due to a degraded insulation); and/or a winding-to-ground fault ("WG fault" or phase-to-ground fault "PG fault," where leakage current flows from phase winding to ground, for example due to degraded insulation)

Motor 108 and/or pump 104 may be coupled to at least one sensor 110 (for example, one sensor 110 or a plurality of sensors 110). The sensor 110 may be configured to receive operational information, status information, and/or other information related to motor 108. Received information may include, among others, motor current data. In some examples, sensor 110 may be a Hall effect sensor that measures each phase current going to the motor 108. Sensor 110 may be included in a drive of motor 108. In some examples, sensor 110 is a located at the output of the drive printed circuit board assembly (PCBA) and before a power supply input to the motor 110. The pump 104, motor 108, and sensor(s) 110 may be included in a pump operational sub-system 106. In some examples, pump operational sub-system 106 may also include one or more controllers (for example, motor control system 120, described below) or other platforms.

Aircraft 102 includes a cockpit 112 from which a pilot 114 pilots the aircraft 102. The cockpit 112 may include various controls, screens, indicators indicator lights, and other features whereby the pilot 114 may receive information relating to aircraft 102's operation and/or may affect aircraft 102's operation. In an example, cockpit 114 includes a motor fault warning feature 116, which may include an indicator light, a warning icon on a screen, or another appropriate visual notification feature. In some examples, motor fault warning feature 116 may include an audible notification feature.

In some examples, aircraft 102 includes one or more aircraft electrical and control units 118. Aircraft 102 may also include motor control system 120. In some examples, motor control system 120 includes one or more controllers for the operation of motor(s) 108. In some examples, motor control system 120 may be located within the aircraft electrical and control units 118. In some examples, motor control system 120 may be located within the pump operational sub-system 106. In some examples, motor control system 120 may be located elsewhere within aircraft 102.

In some examples, one or more controls of cockpit 112 may send data to and/or receive data from components of pump operational sub-system 106 (for example, with sensor(s) 110 and/or motor 108) directly, or via a network 112. In some examples, one or more controls of cockpit 112 may send data to and/or receive data from aircraft electrical and control units 118 directly, or via a network 112. In some examples, one or more controls of cockpit 112 may send data to and/or receive data from motor control system 120 directly, or via a network 112. In some examples, aircraft electrical and control units 118 may send data to and/or receive data from components of pump operational sub-system 106 (for example, with sensor(s) 110 and/or motor 108), or via a network 112. In some examples, motor control system 120 may send data to and/or receive data from components of pump operational sub-system 106 (for example, with sensor(s) 110 and/or motor 108), or via a network 112.

In some examples, a fault detection and remaining useful life (hereinafter "RUL") prediction platform 124 includes a diagnostic application 126 and a prognostic application 128. The fault detection and RUL prediction platform 124 (for examples, models and algorithms carried out by the components of diagnostic application 126 and/or prognostic application 128) may be executed within pump operational sub-system 106, within/by motor control system 120, within aircraft electrical and control units 118, within another component of aircraft 102, or from a remote location. In some examples, fault detection and RUL prediction platform 124 includes one or more controllers.

Fault detection and RUL prediction platform 124 may receive data (for example, at diagnostic application 126) from sensor(s) 110, in addition to data from other sources in some examples. Prognostic application 128 may receive data outputs from diagnostic application 126, in addition to data from other sources in some examples. Output data from fault detection and RUL prediction platform 124 (for examples, from diagnostic application 126 and/or prognostic application 128) may be output/sent to a cockpit 112, for example, to motor fault warning feature 116. Output data from fault detection and RUL prediction platform 124 (for examples, from diagnostic application 126 and/or prognostic application 128) may be output/sent to user interface 134, for display on a display of device 130, where it may be viewed and/or interacted with by a user 132.

In some examples, user interface 134 may include maintenance planning features, where the output of fault detection and RUL prediction platform 124 may be displayed (for example, indicating that one or more motor(s) 108 will be in need of maintenance in a certain timeframe. User 132 may be a maintenance worker or another employee of a maintenance enterprise, air travel enterprise, military personnel, or another user type. User 132 may utilize user interface 134 to review the output of fault detection and RUL prediction platform 124 and to schedule and/or plan required maintenance. Maintenance may include replacement of one or more components of motor(s) 108, replacement of motor(s) 108, or fixing/modifying one or more components of motor(s) 108. In an example, user interface 134 is a web application. In other examples, user interface 134 is a device application. In some examples, device 130 may be a desktop computer, a laptop computer, a tablet, a cell phone, a smart TV, a smart wearable device, or other appropriate electronic device which is capable of displaying and facilitating user interaction with the user interface 134.

In some examples, database 136 may store data from sensor(s) 110, data from components of fault detection and RUL prediction platform 124 (for example, diagnostic application 126 and/or prognostic application 128), data from a maintenance system associated with user 132, interaction data associated with user interface 134, and/or other data. Database 136 as described herein may be of any appropriate database type, including distributed, centralized, relational/SQL, object-oriented, column-oriented, NoSQL, cloud-based, on-premises, operational, analytical, flat-file, network, graphical, time series, multi-model, and/or other database types. Although the database 136 as described and shown herein is described as a single standalone database for the purpose of illustrating the particular examples described, in some examples, the database 136 may be wholly or partially combined with other databases (including databases described relating to these examples and other enterprise databases), or may represent a plurality of databases. In some examples, fault detection and RUL prediction platform 124 (including diagnostic application 126 and/or prognostic application 128) may receive data from sensor(s) 110 directly or semi-directly through network 122. In some examples, fault detection and RUL prediction platform 124 (including diagnostic application 126 and/or prognostic application 128) may receive data from sensor(s) 110 from database 136 (directly or through network 122). In some examples, training data for training of models of fault detection and RUL prediction platform 124 may be stored in database 136.

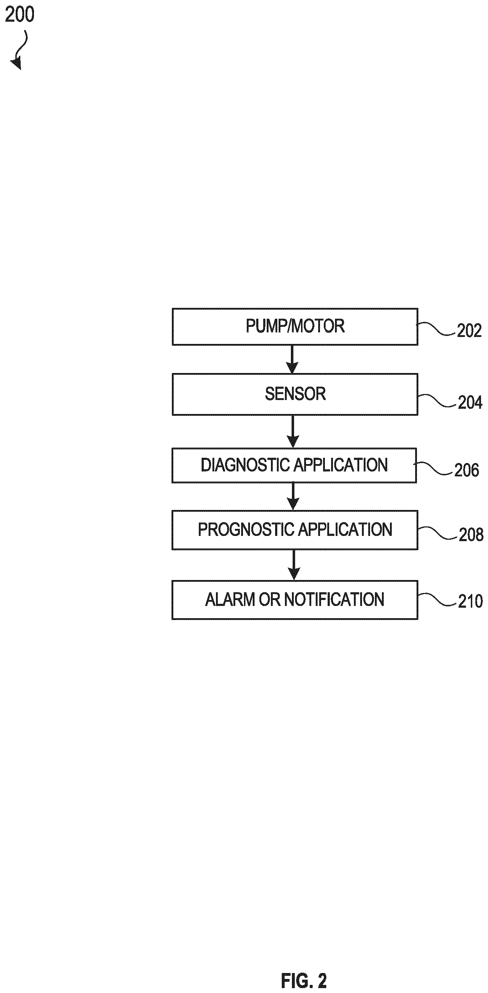

FIG. 2 illustrates an example architecture 200 for performing fault detection and RUL prediction, within the example system of FIG. 1. A motor 202 (in some examples, an electric motor utilized to drive a pump or compressor) may be monitored by one or more sensors 204. The sensor 204 may gather information/data relating to the status and operation of motor 202, for example data three-phase current data and related sequence components. The sensor data from sensor 204 may be stored in a database in some examples. Sensor data from sensor 204 is received by a diagnostic application 206. In some examples, sensor data is determined continuously by sensor 204. In other examples, sensor data is determined intermittently or periodically by sensor 204. In some examples, sensor data is received continuously by diagnostic application 206. In other examples, sensor data is received intermittently or periodically by diagnostic application 206.

Diagnostic application 206 receives sensor data from sensor 204. In some examples, a controller (for example, a controller of a motor control system such as motor control system 120) may be configured to carry out the operations of diagnostic application 206. As will be described in more detail below, diagnostic application 206 determines health of motor 202 (for example, winding health) based on the sensor data. For example, the sensor data bay be used as an indicator of fault occurrence, fault severity, and/or fault type. In some examples, receipt of a negative sequence component may be indicative of a PP fault and/or IT fault. In some examples, receipt of a zero sequence component (or higher) may be indicative of a PG fault. The value of the sequence component may indicate severity of the fault. Diagnostic application 206 generates an output health index of the motor 202. The health index is received by a prognostic application 208. In some examples, diagnostic application 206 operates periodically (for example, a given number of seconds, minutes, hours, or days between runs). In some examples, diagnostic application 206 operates continuously.

Prognostic application 208 receives the health index from diagnostic application 206. In some examples, a controller (for example, a controller of a motor control system such as motor control system 120) may be configured to carry out the operations of prognostic application 208. As will be described in more detail below, prognostic application 208 may predict a performance trend and/or a time at which the motor 202 (for example, the motor winding) will reach a degraded state.

The prediction from prognostic application 208 may be automatically communicated to a receiver user (for example, to a user via a user interface, or to a pilot via an indicator) as an alarm or notification 210. This notification of the prediction may alert the receiver user that a failure is imminent (and therefore that the motor should be shut down and/or maintained immediately), or alternatively that maintenance should be scheduled for a non-imminent time in the future that maximizes motor life while minimizing downtime. This allows for efficient scheduling of predictive maintenance of motor 202 and, in some examples, other motors within the same network/group of motors. This allows for cost-effective operation of aircraft and maintenance groups, as well as helping to ensure safe operation of the motors in an environment where safety is particularly crucial.

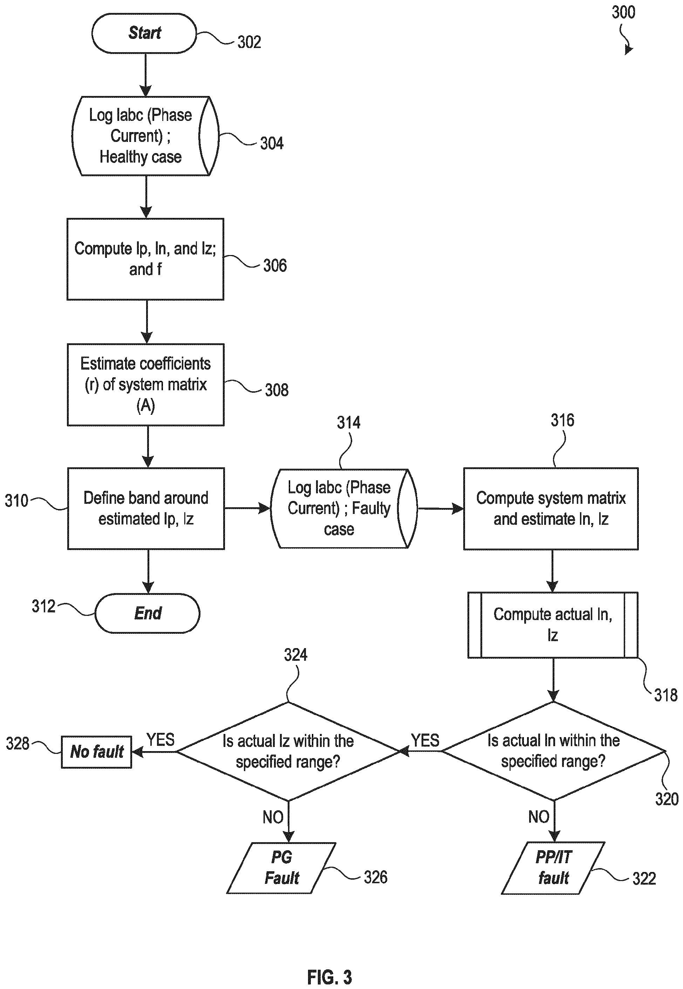

FIG. 3 illustrates an example flowchart 300 for a diagnostic application 206 of the architecture 200 of FIG. 2. At operation 302, the flowchart 300 begins, and a training process can begin. The training process encompasses operations 302 through 312, and may be performed periodically (for example, as new training data is received or generated, as motor type or motor components change, etc.). The diagnostic application 206 may comprise a machine learning/artificial intelligence model to generate the appropriate model/algorithm to apply to the ultimately received sensor data.

At operation 304, training sensor data is received (for example, including three phase current data). This training sensor data may be data collected from an actual motor over its RUL in some examples. In other examples, because may take a period of time to actual motor RUL data (for example, a year, depending on the reliability of the motor), data from a motor-life simulation program or model may be utilized. The simulation data can be gathered for a healthy motor operation, and for fault operations (where different types of faults are intentionally simulated and the associated simulated sensor data is gathered). This motor-life simulation data can then be validated against actual motor data. Generating simulation data and then validating the simulated data allows for adequate training data to be collected in a time-effective manner. The machine learning model may learn from this training data which currents indicate faults and which indicate health, as well as severity and type of fault.

At operation 306, lp (phase positive sequence indicator), ln (phase negative sequence indicator), lz (phase zero sequence indicator), and f (frequency of the motor current) are computed. At operation 308, coefficients r (a weight vector that is multiplied to the system matrix A to estimate negative and zero sequence) of a system matrix A (a system matrix having columns as a function of lp and Ns both linear and nonlinear terms) are estimated. At operation 310, a band is defined around the estimated lp and lz. This band may define a threshold within which the motor is defined as having a healthy operating status. At operation 312, the training exercise may be completed. The training process may be repeated periodically as desired. In some examples, the training process may be continuous or intermittent. The model may be trained using healthy test data to estimate r. Once the model is trained, when it is applied to a new set of data, the value of lz and ln for healthy case can be estimated and any deviation from these numbers indicate a presence of fault in a system (PP/IT/PG), as further described below.

Operations 314 through 328 may correspond to the model receiving sensor data from an actual installed motor, and applying the diagnostics model/algorithm that was learned in the training process. At operation 316, a system matrix is computed, and ln and lz are estimated. At operation 318, actual ln and lz values are calculated. At operation 320, a determination may be made whether the actual ln is within the defined specified range (based on the band defined at operation 310).

If the actual ln is not within the specified range, then the motor is determined to have a PP fault and/or an IT fault 322. If the actual ln is within the specified range, the process moves to operation 324. ln may be considered to be a "Change in Negative sequence with respect to baseline"; that is, it may represent the change in the sequence component that is being monitored (the negative sequence). The change may be either an increase or a decrease. Therefore, in some examples, an absolute value of the change in the value may be utilized.

At operation 324, a determination may be made whether the actual lz is within the defined specified range (based on the band defined at operation 310). lz may be considered to be a "Change in Zero sequence with respect to baseline"; that is, it may represent the change in the sequence component that is being monitored (the zero sequence). The change may be either an increase or a decrease. Therefore, in some examples, an absolute value of the change in the value may be utilized.

If the actual lz is not within the specified range, then the motor is determined to have a PG fault 326. If the actual lz is within the specified range, the motor is determined to be in healthy operation and to have no fault 328. A generated health indicator comprises one or more of these final determinations 328, 326, 322.

The process of operations 314 through 328 my occur intermittently/periodically or continuously, generating health indicators of the motor at different time based on updated sensor data that is received.

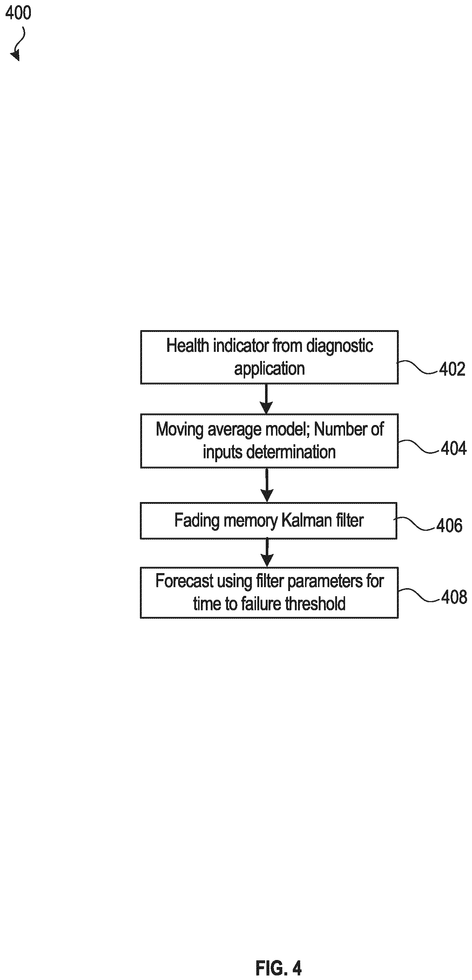

FIG. 4 illustrates an example architecture 400 for a prognostic application 208 of the architecture 200 of FIG. 2. At operation 402, a health indicator is received from a diagnostic application. The health indicator may indicate a fault, a type of fault, no fault, and/or other information related to motor health. At operation 404, health indicators of the motor are tracked over time as they are received. In some examples, health indicators are continuously monitored. In some examples, health indicators are periodically monitored.

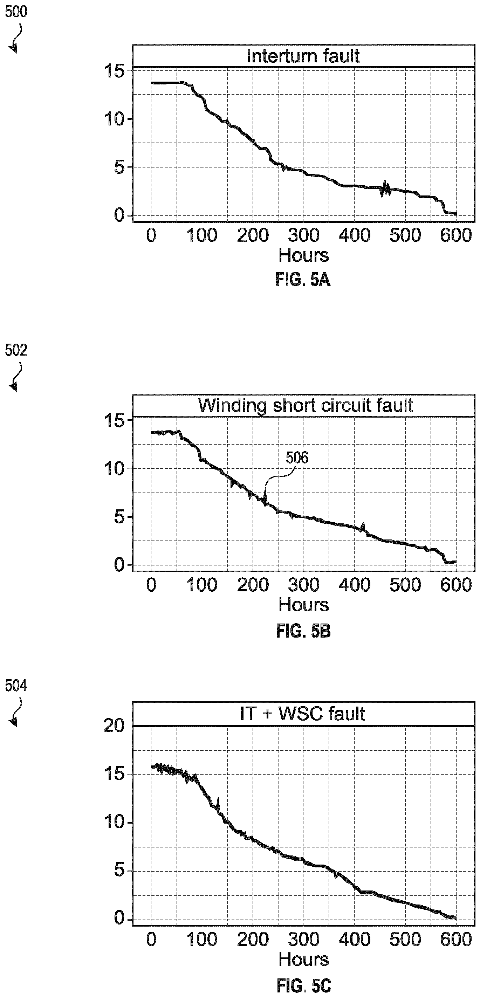

FIG. 5A illustrates an example health indicator trend 500 over time for an interturn (IT) fault. FIG. 5B illustrates an example health indicator trend 502 over time for a winding short circuit (WSC) fault. FIG. 5C illustrates an example health indicator trend 504 over time for both an interturn (IT) fault and a winding short circuit (WSC) fault. These health indicator trends illustrate that although various data points may appear to be outliers or noise (for example, see point 506), the health indicators follow an overall degradation trend over time, as the health indicator value (Y-axis) decreases as the lifetime of the pump increases (X-axis).

Referring back to FIG. 4, at operation 404, the health indicator data points are processed in a moving average model, where the number of measurements to be input into the moving average model and the fading memory Kalman filter is identified such that the degradation trend is not lost due to the averaging step(s) occurring in the moving average model. This moving average step may function to smooth out the health indicator trends and reduce the effects of outlier/noise datapoints. The number of inputs may be determined via a monotonicity check of an increasing degradation trend/forecast.

At operation 406, a fading memory Kalman filter is applied to the de-noised data trend. The algorithm of the Kalman filter utilizes a fading memory, where increased weights are assigned to more recent data points, so that sudden changes in degradation due to motor usage can be captured efficiently.

At operation 408, a forecast (predicted) RUL for the motor is generated. The forecast RUL may be generated by utilizing filter parameters for a time-to-failure threshold.

In further operations, as indicated above, an alarm or notification may be sent based on forecast RUL. Based on the preferences of the pilot, maintenance user, or other user or enterprise, the alarms/notifications may be sent at differing thresholds. For example, if a forecast RUL is below a predetermined threshold number of hours, then a notification/alarm may be sent. The type of notification or alarm may also be determined based on the forecast RUL. In an example, if a forecast RUL is below a first higher predetermined threshold, a notification may be sent to a user interface; if the forecast RUL is below both the first higher predetermined threshold and below a second lower predetermined threshold (indicating a more imminent predicted failure/fault), then both a notification to a user interface and an alarm to a cockpit may be sent.

In some examples, where it is known how far in advance a notification or alarm is desired to be sent, the model may be trained using training data that maximizes the algorithm accuracy at that desired timeframe (i.e. a certain desired number of hours of motor lifetime).

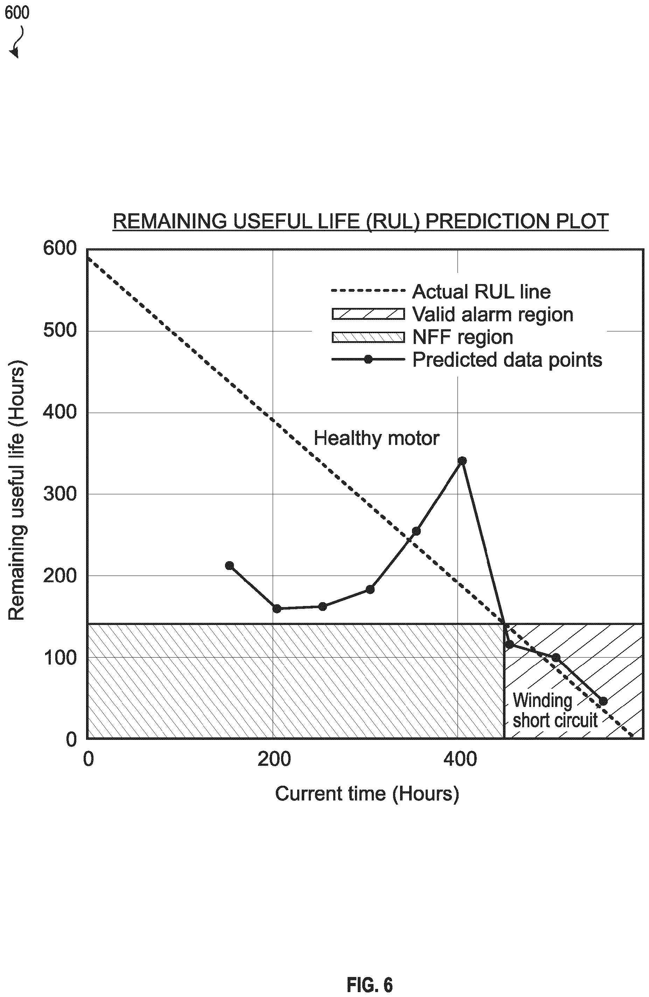

FIG. 6 illustrates an example plot 600 of predicted (forecast) RUL (Y-axis, hours) of a motor compared to actual RUL data. Plot 600 illustrates that the predicted RUL trends very closely with the actual RUL for the motor from the point representing about 50% of degraded life of the motor stator (roughly between 300 hours and 400 hours of current time in this particular example).

In examples, the operation of the motor may be altered based on a different stress or load being applied to the motor during operation. In this case, the model may be retrained as described above on new training data that considers the altered operation of the motor. New sensor data may then be received at the diagnostic application, which will predict updated health indicators (on an associated new, different degradation trend). The prognostic application will forecast a new predicted RUL. If the stress is increased, the predicted RUL may forecast a lesser predicted RUL (e.g. a sooner failure or end of life). This may, in some examples, be used to proactively alter motor operation to extend the RUL of the motor. For example, if motor operation is altered (for example, load decreased) so that stress on the motor is decreased, then the predicted RUL may increase (e.g. a later failure or end of life).

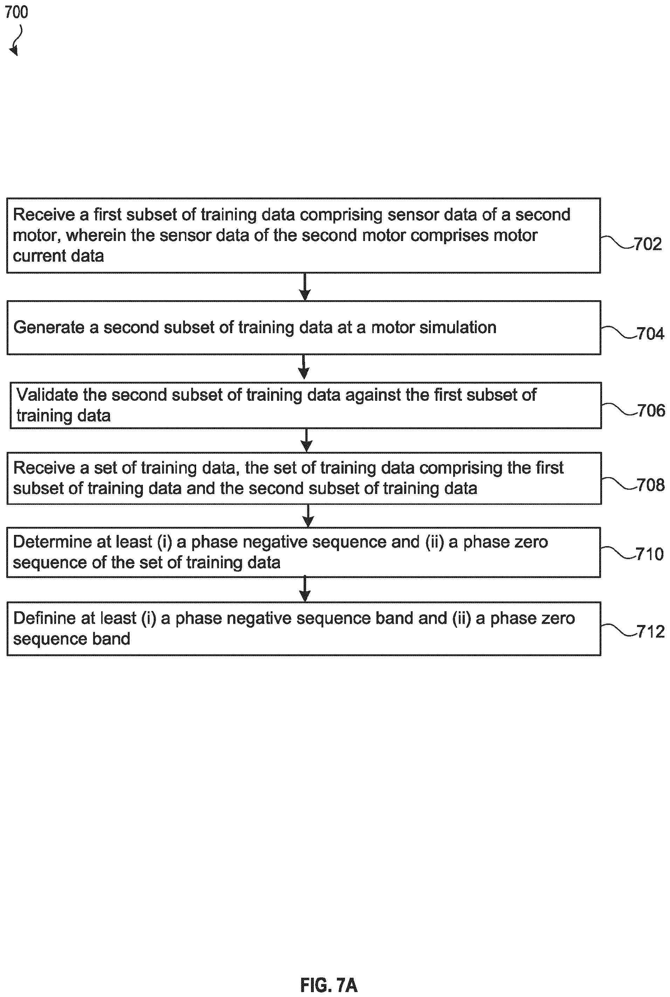

FIG. 7A illustrates an example method for training a fault detection and remaining useful life prediction model, according to an example. In some examples, the operations of FIG. 7A may be carried out by a controller, for example, a controller of a motor control system such as motor control system 120. At operation 702, a first subset of training data is received, wherein the first subset of training data includes sensor data of an actual motor, wherein the sensor data of the motor comprises motor current data.

At operation 704, a second subset of training data is generated at a motor simulation program or model (the second subset of data comprises motor current data of a simulated motor).

In some examples, the first subset of training data may include data relating to a healthy pump operation, may include data relating to one or more faults, or may include both healthy operation and fault data. In some examples, the second subset of training data may include data relating to a healthy pump operation, may include data relating to one or more faults, or may include both healthy operation and fault data.

At operation 706, the second subset of data is validated against the first subset of training data.

At operation 708, a set of training data is received, the set of training data including the first subset of training data (related to the actual pump) and the second subset of training data (simulation-generated). The set of training data may include motor current data.

At operation 710, various factors may be estimated and calculated as described in further detail above, including at least a phase negative sequence and a phase zero sequence (of the set of training data).

At operation 712, at least a phase negative sequence band and a phase zero sequence band are defined. In some examples, other bands (such as a phase positive sequence band) may also be defined.

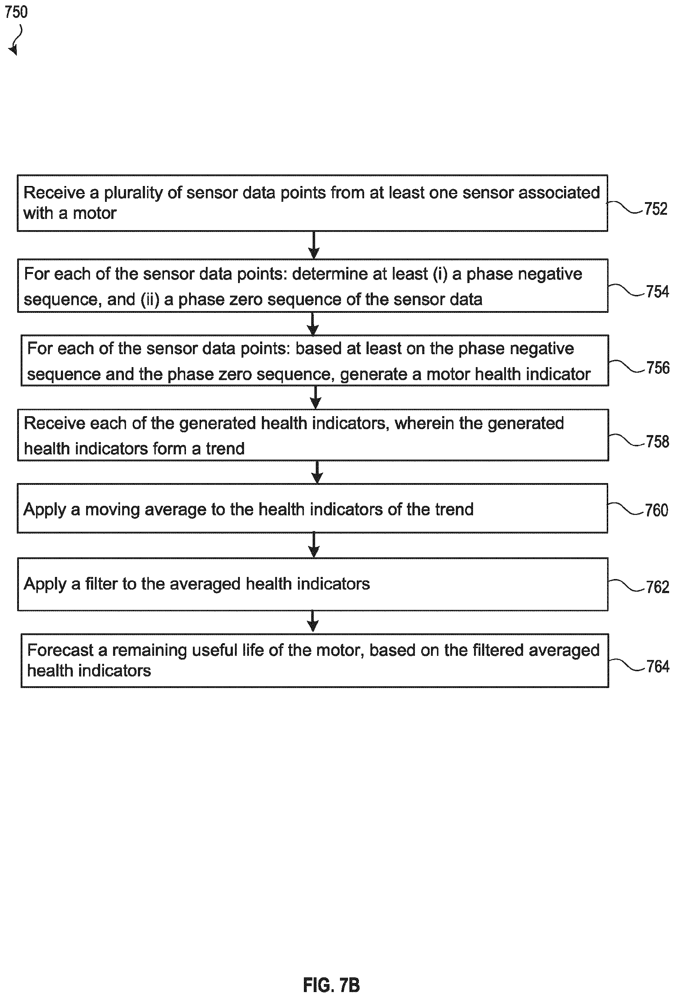

FIG. 7B illustrates an example method for performing fault detection and remaining useful life prediction, according to an example. In some examples, the operations of FIG. 7B may be carried out by a controller, for example, a controller of a motor control system such as motor control system 120. At operation 752, a plurality of sensor data points are received from at least one sensor associated with a motor. Each of the plurality of sensor data points may be associated with a time at which the sensor data was taken from the motor. In some examples, the sensor data points comprise motor current data.

In some examples, the motor is coupled to a pump, for example, to drive the pump. In some examples the motor is an electric motor. In some examples, the motor is installed in an aerospace environment. In some examples, the pump is a fuel pump. In some examples, the motor is one of a plurality of motors, the pump is one of a plurality of motors, each of the plurality of motors is coupled to one of the plurality of pumps, and a plurality of sensor data points is received for each of the plurality of motors.

At operation 754, for each of the sensor data points, various factors may be estimated and calculated as described in further detail above, including at least a phase negative sequence and a phase zero sequence.

In some examples, it may be determined that the phase negative sequence does not fall within a predetermined phase negative sequence band, and therefore that there is at least one of a phase-to-phase fault or an interturn fault in the motor. In some examples, it may be determined that the phase zero sequence does not fall within a predetermined phase zero sequence band, and therefore that there is a phase-to-ground fault in the motor. In some examples, it may be determined that the phase zero sequence falls within a predetermined phase zero sequence band and that the phase negative sequence falls within a predetermined phase negative sequence band; and therefore that there is no fault in the motor.

At operation 756, for each of the sensor data points, based at least on the phase negative sequence and the phase zero sequence, generate a motor health indicator.

At operation 758, each generated health indicator associated with the motor is received, and the health indicators form a trend (for example, a degradation trend of a motor winding).

At operation 760, a moving average is applied to the health indicators of the trend, for example, to de-noise the health indicator trend data.

At operation 762, a filter is applied to the de-noised, averaged health indicators.

At operation 764, a RUL of the motor is forecasted based on the filtered averaged health indicators.

In some examples, it may be determined that the forecasted remaining useful life is below a threshold period of time, and a notification may be automatically sent to a user interface. In some examples, the motor may be scheduled for maintenance (in some examples, the motor may be automatically scheduled; in other examples, the motor may be scheduled by a user), based on receiving the notification at the user interface. In some examples, it may be determined that the forecasted remaining useful life is below a threshold period of time, and an alarm may be automatically sent to a cockpit, wherein the alarm causes a warning light to illuminate in the cockpit.

In some examples, the operation of the motor may be altered (for example, operating factors may be adjusted to decrease stress on the motor) based at least on the forecasted remaining useful life.

In some examples, under fault condition, the obtained real time health index values (i.e. sequence components), may be received at a developed motor simulation program or model to estimate the motor winding fault severity. In example practical scenarios, it may be needed to open the motor to determine how much physical winding degradation has happened inside. The approach of back feeding the obtained data (i.e. sequence components, RMS values of three phase currents, etc.) to the simulation program or model may help the user (for example, a maintenance user) to know the severity of fault within motor that led to the change in healthy index. In some examples, this aids in developing effective motor digital twins/ programs or models, especially under fault conditions.

In some examples, a motor simulation program or model user can increase fault severity for inter turn, phase to phase and phase to ground faults, and may obtain the corresponding change in the sequence components and RMS values of current. If this change matches with the actual motor change in the sequence component and RMS values, then the level of fault severity inside the motor for a given operation condition may be determined without opening the motor.

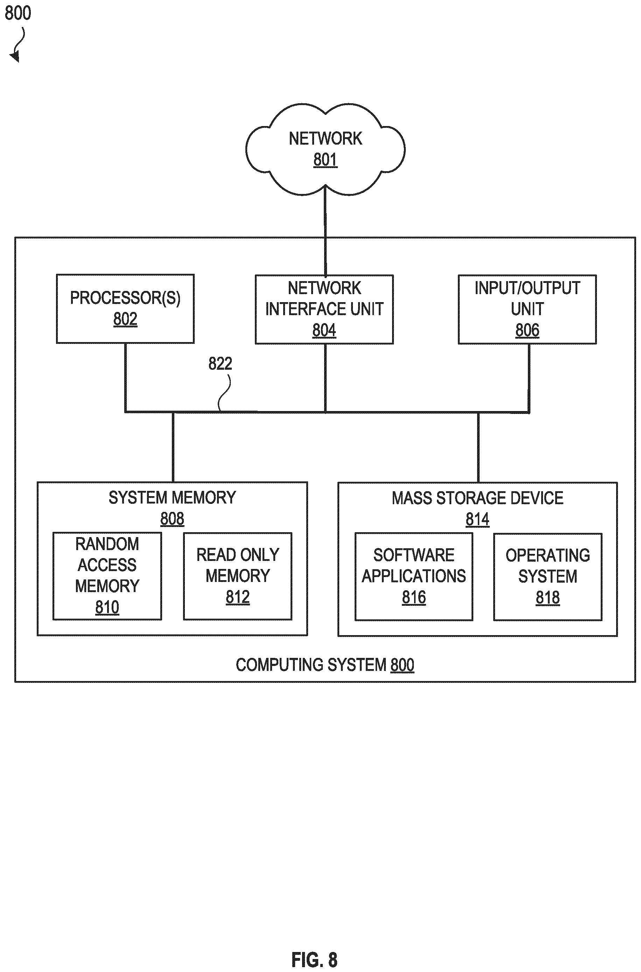

FIG. 8 illustrates an example block diagram of a virtual or physical computing system 800. One or more aspects of the computing system 800 can be used to implement the systems described herein, store instructions described herein, and preform operations described herein. System 800 may be integrated with or comprised within a motor control system (for example, motor control system 120) as described herein.

In the embodiment shown, the computing system 800 includes one or more processors 802, a system memory 808, and a system bus 822 that couples the system memory 808 to the one or more processors 802. The system memory 808 includes RAM (Random Access Memory) 810 and ROM (Read-Only Memory) 812. A basic input/output system that contains the basic routines that help to transfer information between elements within the computing system 800, such as during startup, is stored in the ROM 812. The computing system 800 further includes a mass storage device 814. The mass storage device 814 is able to store software instructions and data. The one or more processors 802 can be one or more central processing units or other processors.

The mass storage device 814 is connected to the one or more processors 802 through a mass storage controller (not shown) connected to the system bus 822. The mass storage device 814 and its associated computer-readable data storage media provide non-volatile, non-transitory storage for the computing system 800. Although the description of computer-readable data storage media contained herein refers to a mass storage device, such as a hard disk or solid-state disk, it should be appreciated by those skilled in the art that computer-readable data storage media can be any available non-transitory, physical device or article of manufacture from which the central display station can read data and/or instructions.

Computer-readable data storage media include volatile and non-volatile, removable and non-removable media implemented in any method or technology for storage of information such as computer-readable software instructions, data structures, program modules or other data. Example types of computer-readable data storage media include, but are not limited to, RAM, ROM, EPROM, EEPROM, flash memory or other solid state memory technology, CD-ROMs, DVD (Digital Versatile Discs), other optical storage media, magnetic cassettes, magnetic tape, magnetic disk storage or other magnetic storage devices, or any other medium which can be used to store the desired information and which can be accessed by the computing system 800.

According to various embodiments of the invention, the computing system 800 may operate in a networked environment using logical connections to remote network devices through the network 801. The network 801 is a computer network, such as an enterprise intranet and/or the Internet. The network 801 can include a LAN, a Wide Area Network (WAN), the Internet, wireless transmission mediums, wired transmission mediums, other networks, and combinations thereof. The computing system 800 may connect to the network 801 through a network interface unit 804 connected to the system bus 822. It should be appreciated that the network interface unit 804 may also be utilized to connect to other types of networks and remote computing systems. The computing system 800 also includes an input/output controller 806 for receiving and processing input from a number of other devices, including a touch user interface display screen, or another type of input device. Similarly, the input/output controller 806 may provide output to a touch user interface display screen or other type of output device.

As mentioned briefly above, the mass storage device 814 and the RAM 810 of the computing system 800 can store software instructions and data. The software instructions include an operating system 818 suitable for controlling the operation of the computing system 800. The mass storage device 814 and/or the RAM 810 also store software instructions, that when executed by the one or more processors 802, cause one or more of the systems, devices, or components described herein to provide functionality described herein. For example, the mass storage device 814 and/or the RAM 810 can store software instructions that, when executed by the one or more processors 802, cause the computing system 800 to receive and execute managing network access control and build system processes.

While particular uses of the technology have been illustrated and discussed above, the disclosed technology can be used with a variety of data structures and processes in accordance with many examples of the technology. The above discussion is not meant to suggest that the disclosed technology is only suitable for implementation with the data structures shown and described above.

This disclosure described some aspects of the present technology with reference to the accompanying drawings, in which only some of the possible aspects were shown. Other aspects can, however, be embodied in many different forms and should not be construed as limited to the aspects set forth herein. Rather, these aspects were provided so that this disclosure was thorough and complete and fully conveyed the scope of the possible aspects to those skilled in the art.

As should be appreciated, the various aspects (e.g., operations, memory arrangements, etc.) described with respect to the figures herein are not intended to limit the technology to the particular aspects described. Accordingly, additional configurations can be used to practice the technology herein and/or some aspects described can be excluded without departing from the methods and systems disclosed herein.

Similarly, where operations of a process are disclosed, those operations are described for purposes of illustrating the present technology and are not intended to limit the disclosure to a particular sequence of operations. For example, the operations can be performed in differing order, two or more operations can be performed concurrently, additional operations can be performed, and disclosed operations can be excluded without departing from the present disclosure. Further, each operation can be accomplished via one or more sub-operations. The disclosed processes can be repeated.

Although specific aspects were described herein, the scope of the technology is not limited to those specific aspects. One skilled in the art will recognize other aspects or improvements that are within the scope of the present technology. Therefore, the specific structure, acts, or operations are disclosed only as illustrative aspects. The scope of the technology is defined by the following claims and any equivalents therein. Examples of the disclosure may be described according to the following aspects.

Aspect 1. A motor control system, comprising: an electric motor coupled to a pump; at least one sensor associated with the motor, the at least one sensor providing a plurality of sensor data points associated with a timestamp; and a controller configured to: receive a plurality of sensor data points from at least one sensor, the at least one sensor associated with a motor, each of the plurality of sensor data points being associated with a time; for each of the sensor data points: determine at least (i) a phase negative sequence, and (ii) a phase zero sequence of the sensor data; and based at least on the phase negative sequence and the phase zero sequence, generate a motor health indicator associated with the time of the sensor data point; receive each of the generated health indicators, wherein the generated health indicators form a trend; apply a moving average to the health indicators of the trend; apply a filter to the averaged health indicators; and forecast a remaining useful life of the motor, based on the filtered averaged health indicators.

Aspect 2. The motor control system of aspect 1, wherein the controller is further configured to: determine that the forecasted remaining useful life is below a threshold period of time; and automatically send a notification to a user interface.

Aspect 3. The motor control system of any of aspects 1-2, wherein the controller is further configured to: determine that the forecasted remaining useful life is below a threshold period of time; and automatically send an alarm to a cockpit, wherein the alarm causes a warning light to illuminate in the cockpit.

Aspect 4. The motor control system of any of aspects 1-3, wherein the sensor data points comprise motor current data.

Aspect 5. The motor control system of any of aspects 1-4, wherein the controller is further configured to: determine that the phase negative sequence does not fall within a predetermined phase negative sequence band; and determine that there is at least one of a phase-to-phase fault or an interturn fault in the motor.

Aspect 6. The motor control system of any of aspects 1-5, wherein the controller is further configured to: determine that the phase zero sequence does not fall within a predetermined phase zero sequence band; and determine that there is a phase-to-ground fault in the motor.

Aspect 7. The motor control system of any of aspects 1-6, wherein the controller is further configured to: determine that the phase zero sequence falls within a predetermined phase zero sequence band; determine that the phase negative sequence falls within a predetermined phase negative sequence band; and determine that there is no fault in the motor.

Aspect 8. A method, comprising: receiving, at a motor control system associated with a motor, a plurality of sensor data points from at least one sensor, the at least one sensor associated with the motor, each of the plurality of sensor data points being associated with a time, wherein the sensor data points comprise motor current data; for each of the sensor data points: determining at least (i) a phase negative sequence, and (ii) a phase zero sequence of the sensor data; and based at least on the phase negative sequence and the phase zero sequence, calculating a motor health indicator associated with the time of the sensor data point; receiving each of the generated health indicators, wherein the generated health indicators form a trend; applying a moving average to the health indicators of the trend; applying a filter to the averaged health indicators; and forecasting a remaining useful life of the motor, based on the filtered averaged health indicators.

Aspect 9. The method of aspect 8, further comprising: determining that the forecasted remaining useful life is below a threshold period of time; and automatically sending a notification to a user interface.

Aspect 10. The method of aspect 9, further comprising: scheduling the motor for maintenance, based on receiving the notification at the user interface.

Aspect 11. The method of aspect 8, further comprising: determining that the forecasted remaining useful life is below a threshold period of time; and automatically sending an alarm to a cockpit, wherein the alarm causes a warning light to illuminate in the cockpit.

Aspect 12. The method of any of aspects 8-11, further comprising: receiving a set of training data, the training data comprising motor current data; determining at least (i) a phase negative sequence and (ii) a phase zero sequence of the set of training data; and defining at least (i) a phase negative sequence band and (ii) a phase zero sequence band.

Aspect 13. The method of aspect 12, further comprising: receiving a first subset of training data, wherein the first subset of training data comprises sensor data of a second motor, wherein the sensor data of the second motor comprises motor current data; generating a second subset of training data, wherein the second subset of data is generated at a motor simulation, wherein the second subset of data comprises motor current data of a simulated motor; and validating the second subset of training data against the first subset of training data, wherein the set of training data comprises the first subset of training data and the second subset of training data.

Aspect 14. The method of aspect 12, further comprising: determining that the phase negative sequence does not fall within the phase negative sequence band; and determining that there is at least one of a phase-to-phase fault or an interturn fault in the motor.

Aspect 15. The method of aspect 12, further comprising: determining that the phase zero sequence does not fall within the phase zero sequence band; and determining that there is a phase-to-ground fault in the motor.

Aspect 16. The method of aspect 12, further comprising: determining that the phase zero sequence falls within the phase zero sequence band; determining that the phase negative sequence falls within the phase negative sequence band; and determining that there is no fault in the motor.

Aspect 17. The method of any of aspects 8-16, further comprising altering the operation of the motor based at least on the forecasted remaining useful life.

Aspect 18. A motor control system, comprising: an electric motor; at least one sensor associated with the motor, the at least one sensor providing a plurality of sensor data points associated with a timestamp, wherein the plurality of sensor data points comprises motor current data; and a controller that calculates a forecasted remaining useful life of the motor, wherein calculating the forecasted remaining useful life comprises: receiving the plurality of sensor data points from at least one sensor, the at least one sensor associated with a motor, each of the plurality of sensor data points being associated with a time; for each of the sensor data points: determining at least (i) a phase negative sequence, and (ii) a phase zero sequence of the sensor data; and based at least on the phase negative sequence and the phase zero sequence, generating a motor health indicator associated with the time of the sensor data point; receiving each of the generated health indicators, wherein the generated health indicators form a trend; applying a moving average to the health indicators of the trend; applying a filter to the averaged health indicators; and forecasting a remaining useful life of the motor, based on the filtered averaged health indicators.

Aspect 19. The motor control system of aspect 18, wherein the motor is coupled to a pump.

Aspect 20. The motor control system of aspect 19, wherein: the motor is one of a plurality of motors, the pump is one of a plurality of motors, each of the plurality of motors is coupled to one of the plurality of pumps, and a plurality of sensor data points is received for each of the plurality of motors.

Aspect 21. The motor control system of aspect 1, wherein the controller is further configured to: determine that the forecasted remaining useful life is below a threshold period of time; and automatically perform at least one of: send a notification to a user interface; and send an alarm to a cockpit, wherein the alarm causes a warning light to illuminate in the cockpit.

Aspect 22. The method of aspect 8, further comprising: determining that the forecasted remaining useful life is below a threshold period of time; and automatically performing at least one of: sending a notification to a user interface; and sending an alarm to a cockpit, wherein the alarm causes a warning light to illuminate in the cockpit.

## Claims

1. A motor control system, comprising:
an electric motor coupled to a pump;
at least one sensor associated with the motor, the at least one sensor providing a plurality of sensor data points associated with a timestamp; and
a controller configured to:
receive a plurality of sensor data points from at least one sensor, the at least one sensor associated with a motor, each of the plurality of sensor data points being associated with a time;
for each of the sensor data points:
determine at least (i) a phase negative sequence, and (ii) a phase zero sequence of the sensor data; and
based at least on the phase negative sequence and the phase zero sequence, generate a motor health indicator associated with the time of the sensor data point;
receive each of the generated health indicators, wherein the generated health indicators form a trend;
apply a moving average to the health indicators of the trend;
apply a filter to the averaged health indicators; and
forecast a remaining useful life of the motor, based on the filtered averaged health indicators.

2. The motor control system of claim 1, wherein the controller is further configured to:
determine that the forecasted remaining useful life is below a threshold period of time; and
automatically perform at least one of:
send a notification to a user interface; and
send an alarm to a cockpit, wherein the alarm causes a warning light to illuminate in the cockpit.

3. The motor control system of any of claims 1-2, wherein the sensor data points comprise motor current data.

4. The motor control system of any of claims 1-3, wherein the controller is further configured to:
determine that the phase negative sequence does not fall within a predetermined phase negative sequence band; and
determine that there is at least one of a phase-to-phase fault or an interturn fault in the motor.

5. The motor control system of any of claims 1-4, wherein the controller is further configured to:
determine that the phase zero sequence does not fall within a predetermined phase zero sequence band; and
determine that there is a phase-to-ground fault in the motor.

6. The motor control system of any of claims 1-5, wherein the controller is further configured to:
determine that the phase zero sequence falls within a predetermined phase zero sequence band;
determine that the phase negative sequence falls within a predetermined phase negative sequence band; and
determine that there is no fault in the motor.

7. A method, comprising:
receiving, at a motor control system associated with a motor, a plurality of sensor data points from at least one sensor, the at least one sensor associated with the motor, each of the plurality of sensor data points being associated with a time, wherein the sensor data points comprise motor current data;
for each of the sensor data points:
determining at least (i) a phase negative sequence, and (ii) a phase zero sequence of the sensor data; and
based at least on the phase negative sequence and the phase zero sequence, calculating a motor health indicator associated with the time of the sensor data point;
receiving each of the generated health indicators, wherein the generated health indicators form a trend;
applying a moving average to the health indicators of the trend;
applying a filter to the averaged health indicators; and
forecasting a remaining useful life of the motor, based on the filtered averaged health indicators.

8. The method of claim 7, further comprising:
determining that the forecasted remaining useful life is below a threshold period of time; and
automatically performing at least one of:
sending a notification to a user interface; and
sending an alarm to a cockpit, wherein the alarm causes a warning light to illuminate in the cockpit.

9. The method of claim 8, further comprising:
scheduling the motor for maintenance, based on receiving the notification at the user interface.

10. The method of any of claims 7-9, further comprising:
receiving a set of training data, the training data comprising motor current data;
determining at least (i) a phase negative sequence and (ii) a phase zero sequence of the set of training data; and
defining at least (i) a phase negative sequence band and (ii) a phase zero sequence band.

11. The method of claim 10, further comprising:
receiving a first subset of training data, wherein the first subset of training data comprises sensor data of a second motor, wherein the sensor data of the second motor comprises motor current data;
generating a second subset of training data, wherein the second subset of data is generated at a motor simulation, wherein the second subset of data comprises motor current data of a simulated motor; and
validating the second subset of training data against the first subset of training data, wherein the set of training data comprises the first subset of training data and the second subset of training data.

12. The method of claim 10, further comprising:
determining that the phase negative sequence does not fall within the phase negative sequence band; and
determining that there is at least one of a phase-to-phase fault or an interturn fault in the motor.

13. The method of claim 10, further comprising:
determining that the phase zero sequence does not fall within the phase zero sequence band; and
determining that there is a phase-to-ground fault in the motor.

14. The method of claim 10, further comprising:
determining that the phase zero sequence falls within the phase zero sequence band;
determining that the phase negative sequence falls within the phase negative sequence band; and
determining that there is no fault in the motor.

15. The method of any of claims 7-14, further comprising altering the operation of the motor based at least on the forecasted remaining useful life.
